Europäisches Patentamt

(19) **European Patent Office**

**Office européen des brevets**

(11) Publication number: **0 176 634**

**A1**

(12) # EUROPEAN PATENT APPLICATION

(21) Application number: **84305330.7**

(22) Date of filing: **06.08.84**

(51) Int. Cl.⁴: **G 01 R 21/00**
**G 01 R 19/00**

(43) Date of publication of application:
**09.04.86 Bulletin 86/15**

(84) Designated Contracting States:
**CH DE FR GB IT LI NL SE**

(71) Applicant: **WATT WATCHER, INC.**
**424 Mulberry Street**
**Milton Delaware(US)**

(72) Inventor: **Wagner, Charles G.**
**424 Mulberry Street**
**Milton Delaware(US)**

(72) Inventor: **Ferguson, John S.**
**115 Carolyn Street**
**Georgetown Delaware(US)**

(74) Representative: **van Berlyn, Ronald Gilbert**
**23, Centre Heights**
**London, NW3 6JG(GB)**

(54) **Device for monitoring consumption of electrical power.**

(57) A device to enable a user to conveniently determine the amount of electrical power being consumed by appliances at any given time is disclosed. A sensing unit is applied externally to the main power supply cable without penetration of the cable sheath and without direct connection with the cable conductors. An induction type or Hall effect sensor unit may be employed. A meter indicating power consumption is installed at a convenient location remote from the sensor unit and is wired to the sensor unit.

**FIG. 1**

EP 0 176 634 A1

0176634

- 1 -

## DEVICE FOR MONITORING CONSUMPTION
## OF ELECTRICAL POWER

The principal object of the present invention is to satisfy a need for a convenient and economical device to enable users to monitor, and thus gain control over, the amount of AC electrical power being consumed by appliances at any given time.

Without such a monitoring means, the user is apt to leave the premises with a number of electrical appliances turned on, which could or should be turned off during the user's absence. A safety or fire hazard can sometimes be created when heavy current-consuming appliances are left unattended.

At the present time, no ready economical means is available for power consumption monitoring without utilizing relatively expensive instrumentation, including means to penetrate or otherwise make contact with the conductors of power supply cables, which is impractical and in some cases illegal.

While certain snap-on meters are known in the prior art which do not require penetration of a cable sheath, these devices are not operable with the multiple (two and three) conductor power supply cables presently in wide use.

The essence of the present invention therefore resides in the provision of a non-penetrating, externally applied sensing unit particularly constructed to coact with AC power supply cables, by electromagnetic induction, or as a Hall effect sensor. An AC signal from the sensor is converted in a 2 volt AC meter which can be read in kilowatt equivalents.

The device is based on the following principles:

(1) The concentric magnetic field around any conductor is directly proportional to the current flowing in the conductor.

(2) Magnetic fields around parallel supply conductors are in opposing relationship, thus creating elliptical fields where the major elliptical axes are across the axes of the parallel conductors.

(3)    Lines of magnetic flux cutting across a conductor will induct current flow in that conductor.  A similar effect can be obtained by the placement of a Hall effect sensor in the flux field generated by a conductor. .

An object of the invention is to provide a device of the above-mentioned type for monitoring power consumption in the home or elsewhere which, except for the sensor, can be constructed from commercially available economical components, thus enabling the manufacturing and sale of the device at relatively low cost.

Another object is to provide a device of the mentioned type which is entirely practical and reliable.

Other objects and advantages of the invention will become apparent during the course of the following detailed description in which:

Figure 1 is a plan view of an externally applied non-penetrating sensing unit in association with a conventional SE/USE power supply cable, the cable being shown in cross section;

Figure 2 is a side elevation of the sensing unit;

Figure 3 is a horizontal section taken on line 3-3 of Figure 2 with parts omitted;

Figure 4 is an enlarged cross sectional view of an induction sensor according to the invention applied externally to the SE/USE cable;

Figure 5 is a similar view of a Hall effect sensor applied to the cable;

Figure 6 is a schematic view of circuitry involved in the device;

Figure 7 is a fragmentary vertical cross section taken through the wall of a building on which the invention is installed;

Figures 8 and 9 are schematic views of other two and three conductor cables with which the power consumption monitor can be used; and

Figure 10 is a view similar to Figure 1 in cross section depicting a sensor unit having only a single magnetically permeable core and electrical sensing element.

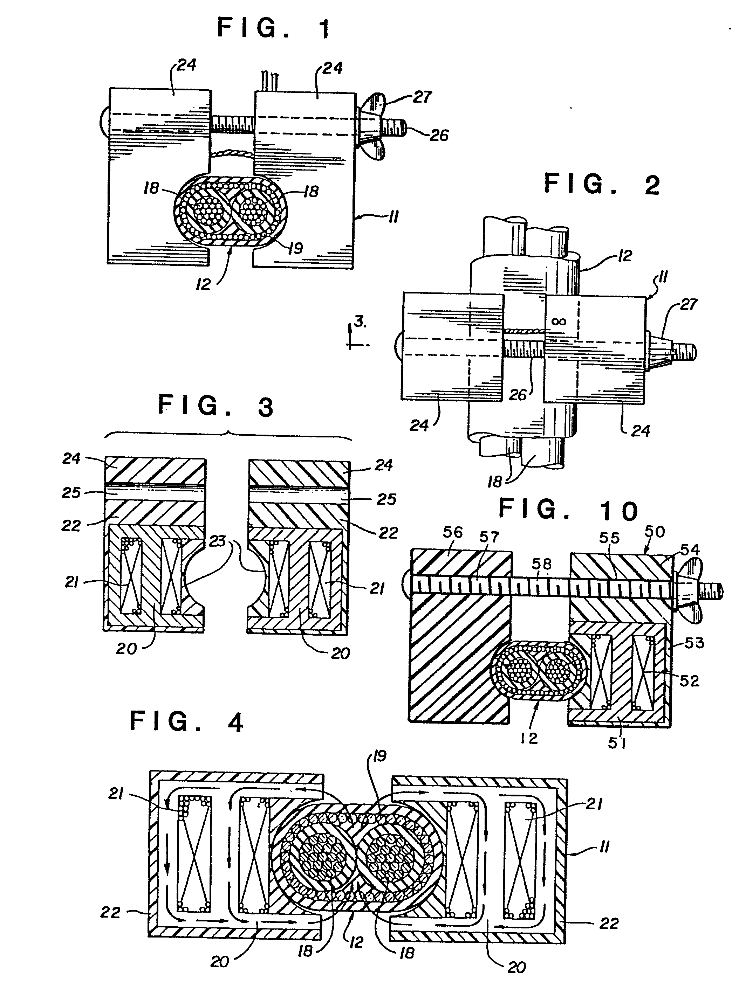

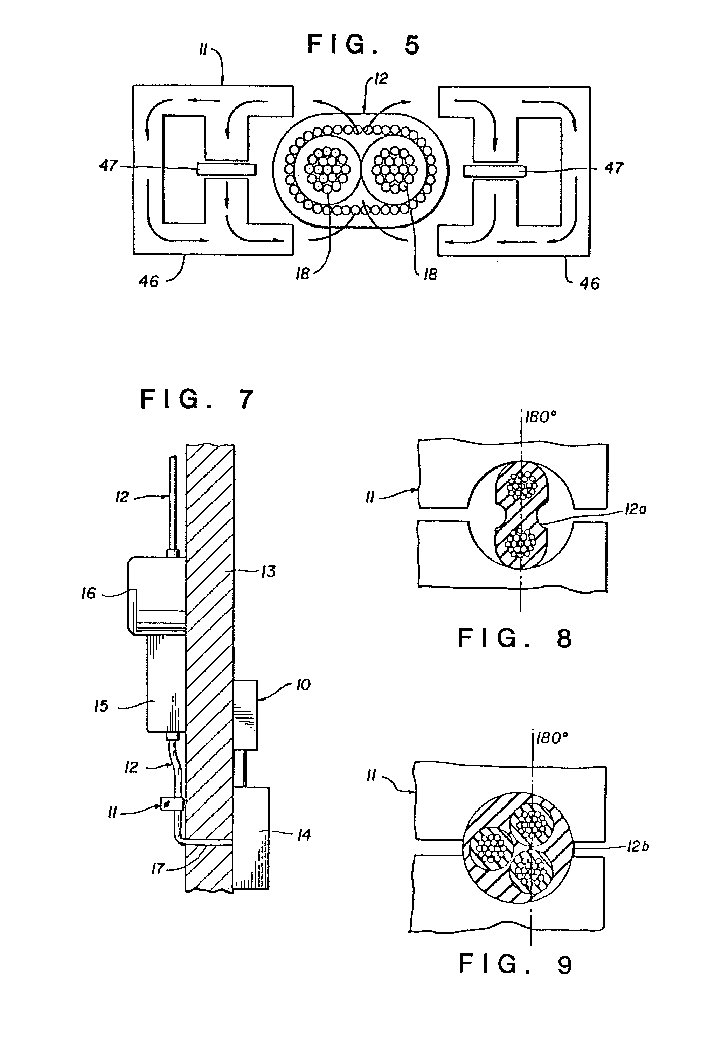

Referring to the drawings in detail wherein like numerals designate like parts, an electrical power consumption monitoring device comprises essentially two main components, namely a commercial digital voltmeter 10 which can be read in kilowatt equivalents and a sensor unit 11, Figure 4, or 11', Figure 5, which can be applied externally to a multiple conductor power supply cable 12.

Figure 7 shows a typical installation of the monitoring device, wherein the numeral 13 designates a building wall on the interior of which is mounted the customary circuit breaker or fuse box 14. An exteriorly mounted junction box 15 and watt hour meter 16, supplied by the power company, are connected in the power supply cable 12 which may pass through the building wall 13 as indicated at 17 for suitable connection with the box 14. As illustrated, the sensor 11 is mounted externally on the power supply cable 12 between the meter 16 and the point where the cable enters the building. It should be understood, however, that the sensor can be applied to the cable 12 at any convenient point outside or inside of the building where the cable is exposed, and in this sense the invention is not limited to the particular arrangement shown in Figure 7. The power consumption indicating meter 10 is installed at any convenient location within the building, as on the wall 13, or elsewhere if preferred.

It should also be understood that in some cases the invention including the sensor 11 and meter or read-out device 10 may be completely portable, whereby a user can apply the sensor 11 to the cable 12 at any point while reading the portable meter. Furthermore, the sensor 11 of the portable unit may be integrated with the meter in some cases to monitor any AC power consuming device having a two or three conductor power supply cable.

The illustrated cable 12, typically a SE/USE power supply cable commonly in wide usage, comprises two side-by-side parallel conductors 18 surrounded by spirally wrapped shielding conductors 19 which carry the neutral or imbalanced remainder of the current. In this invention, the imbalance is negated from the high supply side and added to the low supply side in terms of flux induced voltage. The cable 12 which has a suitable insulating sheath is generally elliptical in cross section. The invention may also be used with non-shielded two and three conductor cables 12a and 12b of the types illustrated in Figures 8 and 9. To allow maximum readings on the meter 10, the cables 12a and 12b should be oriented relative to the sensor 11, as shown in Figures 8 and 9.

The heart of the invention resides in the induction or Hall effect sensor 11 or 11'. The sensor 11, which utilizes the induction effect in its operation, comprises two identical opposing laminated iron cores 20 placed 180° apart in the plane common to the parallel conductors 18. Each iron core is wrapped with a multi-turn coil 21 of conducting wire and each iron core with its coil is encapsulated in epoxy 22 or equivalent non-conducting and non-magnetic material. The epoxy encapsulation is recessed as at 23 to snugly engage the opposite sides of the cable 12 when the sensor is applied thereto. Bosses 24 are molded on the encapsulating material and these bosses have aligned openings 25 receiving a clamping bolt 26 carrying a winged nut 27, whereby the two cores 20 and their encapsulated coils 21 can be clampingly engaged with opposite sides of the cable 12 without any penetration of the cable sheath and without establishing a physical connection with the two conductor branches 18.

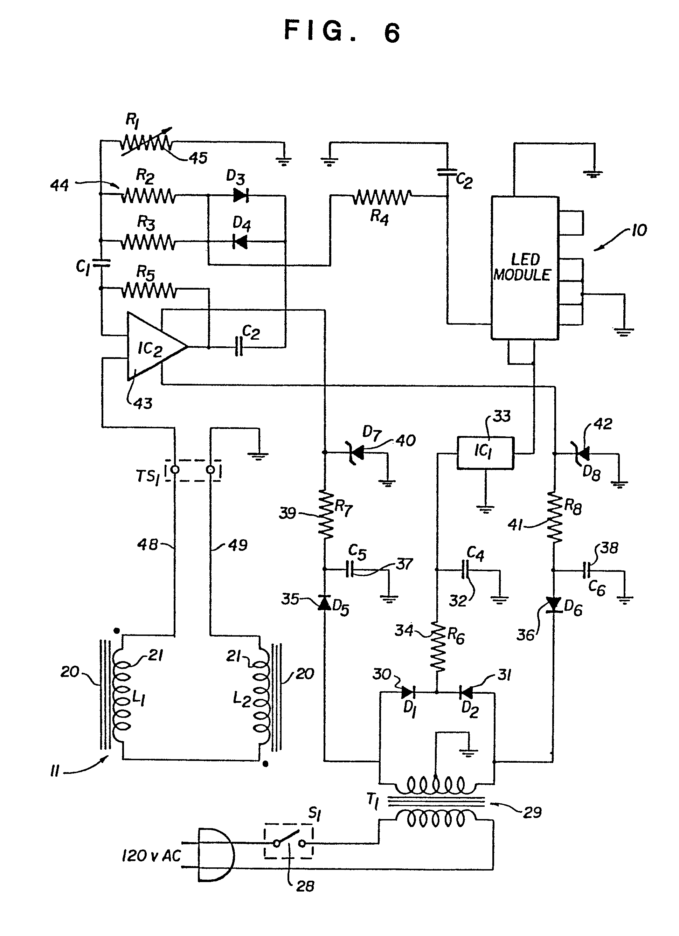

As shown in Figure 6, the two induction coils 21 are electrically connected in series aiding relationship, whereby the total voltage signal produced by the coils is sent to the meter or read-out device 10.

Additionally, as shown in Figure 6, 120 volts AC is applied through on-off switch 28 to transformer 29. A conventional center tapped full wave rectifier using diodes 30 and 31 provides pulsating DC to filter capacitor 32 and 5 volt regulator 33. Regulated 5 volts DC is supplied to DC meter 10. Resistor 34 is used to limit dissipation in regulator 33 and provides surge protection for diodes 30 and 31.

Diodes 35 and 36 are connected as conventional half wave rectifiers for positive and negative voltage output and capacitors 37 and 38 are filter capacitors. Resistance 39 and diode 40 form a conventional zener regulator circuit for +15 volts DC regulator 33, and resistor 41 and diode 42 form a similar regulator circuit for -15 volts DC.

The $\pm$15 volts supplies provide operating voltages for integrated circuit module 43, an operational amplifier working in conjunction with associated components to provide RMS to DC conversion in the converter circuit 44. Potentiometer 45 is for calibration adjustment.

Due to the elliptical fields of flux generated around parallel conductors 18, Figure 4, the two iron cores 20 collect and channel the bulk of the magnetic flux through the cores, which induces an AC voltage in the two coils 21 in direct proportion to the current flowing in the parallel conductors 18, the coils 21 being connected in series aiding relationship. This voltage is delivered to the converter 44, as described.

In an alternate embodiment of the invention shown in Figure 5, the sensor 11' is a Hall effect sensor instead of an induction sensor and the induction coils 21 are omitted. In lieu thereof, two laminated iron cores 46 are placed relative to the cable assembly 12 in the same manner previously described, namely, 180° apart in a plane passing through the axes of the two parallel cable conductors 18. Two Hall effect devices 47 are placed within gaps of the two iron cores 46 with their output terminals connected to the wires 48 and 49, Figure 6. The system operates with the Hall effect devices in the identical manner that it operates with the two induction coils, with relation to the cable assembly 12. The Hall effect devices 47 are of a type manufactured by Ohio Semitronics, Inc., 1205 Chesapeake Ave., Columbus, Ohio 43212, Model No. HP 316 or equivalent devices.

In either embodiment of the invention, it is only necessary to apply the sensor 11 or 11' externally to the cable assembly 12, as shown in the drawings, and to close the switch 28 to activate the power supply. The AC signal from the sensor 11 or 11' is instantly converted to a DC signal in the RMS to DC converter 44, which signal is read in kilowatt equivalents on the DC meter 10.

As shown in Figure 10, it is not essential to the operation of the system to provide two opposing magnetically permeable cores each having an induction coil or Hall effect element, as previously described. Instead, Figure 10, the power cable attached sensor unit 50 may include a single magnetically permeable (iron) core 51 whose particular shape is not critical. A single induction coil 52 is wound on the core 51, as shown. In some cases, a Hall effect sensor, as disclosed in Figure 5, may be used, in which case only a single core element 46 and Hall effect device 47 is utilized.

With continued reference to Figure 10, the single core element 51 and coil 52 are encased in epoxy 53 shaped to provide a boss 54 having a bolt receiving aperture 55.

For securing the sensor unit 50 to the power cable 12 where only a single core 51 is utilized, an opposing blank block 56 formed of epoxy or sturdy plastics material having the same shape as the core and coil containing element is provided. The block 56 contains no electromagnetic components. The block 56 has an aperture 57 to register with the opposing aperture 55 and receive a bolt 58 serving to secure the single core sensor unit 50 in assembled relationship with the power cable 12.

The same arrangement is employed if the sensor unit is of the Hall effect type, shown in Figure 5. In this case, only one magnetically permeable core is utilized and the opposing unit on the other side of the power cable is a blank block serving only to complete the attachment of the sensing unit clampingly to the exterior of the power supply cable 12 without penetrating the latter.

The mode of operation of the device constructed with either one or two magnetically permeable cores and associated induction coil or coils or Hall effect element or elements is essentially as described. The circuitry shown in Figure 6 for a dual core and coil embodiment is also basically unchanged by the elimination of one core and coil.

The present invention can be utilized in single phase or three phase AC power systems or in DC power systems, without any significant change in the circuitry of Figure 6.

A home owner or other user of the invention, by observing the meter 10, can readily determine at any time whether normal power consumption or excessive consumption is occurring. A normal reading on the meter 10 might be reflected by the numeral 2 or 3, while an excessive reading would be anything above 2 or 3. If excessive power consumption is occurring, corrective steps can be taken as by shutting off or turning down high energy consuming appliances. The device can indicate power consumption of individual appliances or entire household power consumption.

CLAIMS

1. A device for monitoring power consumption where power is supplied through a cable assembly having two parallel current carrying conductors, said device comprising a sensor of current flowing in the two conductors including two separate cores of high magnetic permeability spaced substantially 180° apart in the plane occupied by the two conductors on opposite sides of the cable assembly in close relationship to the cable assembly without penetrating the assembly, a read-out instrument calibrated in units of power consumed, and power supply and voltage converter means electrically connected to the sensor and read-out instrument.

2. A device for monitoring power consumption as defined in claim 1, and the sensor operating by induction effect and including two induction coils wound on the separate magnetic cores and being connected in series aiding relationship, the sensor being electrically connected with said converter means.

3. A device for monitoring power consumption as defined in claim 1, and the sensor comprising a Hall effect sensor in which said cores have gaps therein, a pair of Hall effect devices positioned in said gaps and being connected in series aiding relationship, and the sensor being electrically connected with said converter means.

4. In a system for monitoring power consumption where electrical power is supplied to appliances through a power cable, a sensor of current flowing in said power cable including at least a core of high magnetic permeability disposed adjacent to the exterior of the power cable, an electrical sensing element associated with said core and being in the path of lines of magnetic flux flowing through the core, a remote read-out instrument calibrated in units of power, and electrical circuit means including power supply means connected between said sensor and said read-out instrument.

FIG. 1

FIG. 2

FIG. 3

FIG. 10

FIG. 4

FIG. 5

47

46

47

46

12

18        18

FIG. 7

12

13

16

15

10

12

14

11

17

FIG. 8

180°

11

12a

FIG. 9

180°

11

12b

FIG. 6

3/3

0176634

## DOCUMENTS CONSIDERED TO BE RELEVANT

| Category | Citation of document with indication, where appropriate, of relevant passages | Relevant to claim | CLASSIFICATION OF THE APPLICATION (Int Cl 4) |
|---|---|---|---|
| A | GB-A-2 068 131  (M.C. SHORTLE) * Abstract; claim 1; figure 1 * | 1,4 | G 01 R   21/00 G 01 R   19/00 |
| | --- | | |
| A | REVIEW OF SCIENTIFIC INSTRUMENTS, vol. 46, no. 3, March 1975, pages 324-325, American Institute of Physics; M. AVINOR et al.: A simple, fast, side-looking current transformer" | | |
| | --- | | |
| A | EP-A-0 082 082  (LA TELEMECANIQUE ELECTRIQUE) | | |
| | --- | | |
| A | GB-A-  960 668  (GENERAL PRECISION) | | |
| | ----- | | |

**TECHNICAL FIELDS SEARCHED (Int Cl 4)**

G 01 R   15/00
G 01 R   21/00
H 01 F   40/00

The present search report has been drawn up for all claims

| Place of search | Date of completion of the search | Examiner |
|---|---|---|
| THE HAGUE | 10-01-1986 | DELPORTE B.P.M. |